# EUROPEAN PATENT SPECIFICATION

(11) **EP 1 190 846 B1**
(45) Date of publication and mention of the grant of the patent: **14.01.2009**
(21) Application number: 01307907.4
(22) Date of filing: 18.09.2001
(51) Int. Cl.: B60C 1/00, B60C 9/00, B32B 25/10, C23C 16/44, B32B 25/04, C23C 14/06, C08J 5/06, C08J 5/12

(54) **Tire comprising a rubber-based composite material**
Reifen enthaltend ein auf Kautschukbasis basierendes Verbundmaterial
Pneu comprenant un matériau composite à base de caoutchouc

(30) Priority: 26.09.2000 JP 2000291768
(43) Date of publication of application: 27.03.2002
(73) Proprietor: Bridgestone Corporation, Tokyo 104-0031 (JP)
(72) Inventor: Kusano, Yukihiro, Kodaira-shi, Tokyo 187-0031 (JP); Yoshikawa, Masato, Kodaira-shi, Tokyo 187-0031 (JP); Zuigyo, Yugo, Kodaira-shi, Tokyo 187-0031 (JP)
(74) Representative: Oxley, Robin John George

(56) References cited:
- EP-A- 0 872 511
- EP-A- 0 922 593
- WO-A-01/83874
- PATENT ABSTRACTS OF JAPAN vol. 1998, no. 06, 30 April 1998 (1998-04-30) & JP 10 053010 A (BRIDGESTONE CORP), 24 February 1998 (1998-02-24)

## Description

The present invention relates to tires which utilize rubber-based composite materials in reinforcing layers thereof. More particularly, the invention relates to rubber-based composite materials that can enhance durability and can reduce their weight when used as a reinforcing material for tires.

As a reinforcing material for rubber-based composite materials to be applied for tires, organic fiber cords and steel cords are heretofore widely used. In such applications, strong adhesion between the rubber and the reinforcing material is important from the viewpoint of durability of the product. Therefore, in conventional composite materials of organic fiber cords and a rubber, the enhancement of the adhesion between both materials has been achieved by subjecting the organic fiber cords to dip treatment in a resorcin/formaldehyde condensate/latex (RFL) adhesive. Furthermore, in a composite of steel cords and a rubber, the steel cords are generally subjected to various plating treatments in order to enhance the adhesion between both materials.

As a reinforcing material for rubber-based composite materials to be applied for tires, use of non-woven fabrics as well as the use of organic fiber cords and steel cords is also known. For example, Japanese Patent Laid-open Publication No. Hei. 10-53010 proposes to apply a rubber-filament fiber composite using a non-woven fabric between a carcass layer and a sidewall portion of a radial tire in order to enhance the rigidity of the sidewall portion and to improve the driving stability of the tire without either damaging the original performances of the tire such as riding comfort and durability or complicating the production method.

As a reinforcing material for rubber-based composite materials, much attention is focused on non-woven fabrics because of their superior abilities to improve performance. The application of non-woven fabrics to tires for further improving their performance have become to be examined. Moreover, the use of reinforcing materials containing non-woven fabrics is expected to be able to increase the design flexibility and the durability of the conventional rubber-based composite materials containing no reinforcing materials.

However, non-woven fabrics can not be enhanced in respect of their adhesiveness through the application of either the conventional dip treatment wherein organic fiber cords are dipped in an RFL adhesive or the plating treatment conventionally applied for steel cords. The reason why is that when these kinds of treatment are applied for non-woven fabrics, desired effects can not be obtained because a non-woven fabric becomes clogged to form a film and its contact area with the rubber to which the non-woven fabric is adhered is reduced.

Accordingly, an object of the present invention is to solve the above mentioned problems, to enhance adhesiveness between a non-woven fabric and a rubber, and to provide a rubber-based composite material the use of which as a reinforcing material for tires can improve the durability thereof and can reduce their weight.

The inventors of the present invention studied diligently to achieve the above mentioned objects. As the result, they have accomplished the present invention through their finding that the above mentioned objects can be achieved by applying a specific coating treatment by the vapour deposition method to the surface of the filaments constituting a non-woven fabric.

Attention is also drawn to the disclosures of WO01/83874A, EP-A-0872511, and EP-A-0922593.

Accordingly, the present invention provides a tire comprising a carcass layer extending between a pair of right and left bead wires, a steel belt disposed in a ring outside the carcass layer in a radial direction, a tread rubber arranged in a road contacting surface portion present outside the belt, and sidewall rubbers on the carcass layer present on both sides of the tread rubber, and reinforcing layers comprising a rubber-based composite material located between the carcass layer and the sidewalls, said rubber-based composite material comprising
a non-woven fabric;
a coating of a metal or metallic compound reactable with sulfur, the coating being formed on the surface of filaments constituting the non-woven fabric by a physical vapour deposition (PVD) method or a chemical vapour deposition (CVD) method; and
a rubber that adheres to the coating forming a continuous layer and covering the non-woven fabric.

The rubber-based composite material of the present invention can enhance the rigidity of the tire using the same as a reinforcing material without deteriorating the durability of the tire. Particularly, in the case of a pneumatic radial tire, the application of such a rubber-based composite material to a sidewall portion of a tire can enhance the rigidity of the sidewall portion and can improve the driving stability of the tire.

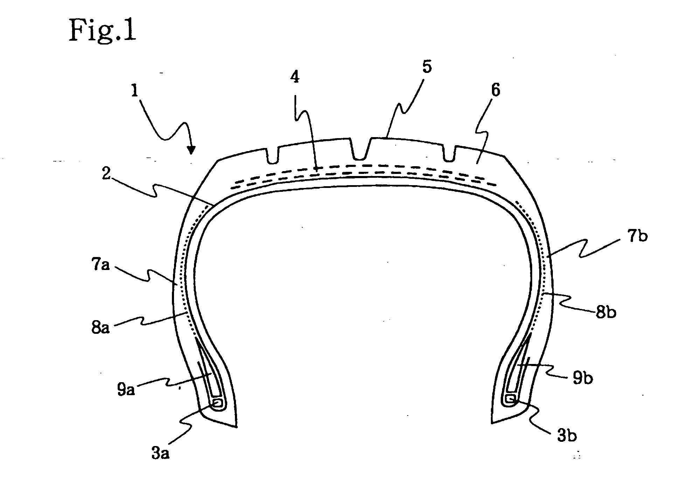

The invention will be further described with reference to the accompanying drawing, wherein Fig. 1 is a cross sectional view of a pneumatic tire of the present invention.

The non-woven fabrics applicable to the present invention are not webs formed by either twisting or weaving multiple bundles of filaments, but are those prepared by the carding process, the paper-making process, the air-laid process, the meltblowing process, the spunbonding process or the like. Preferably applicable methods for binding filaments in webs other than those formed by the meltblowing or spunbonding process include the welding process, the process using a binder, and the water-stream-entangling or needle punch process in which filaments are entangled by the force of water streams or needles. Particularly, non-woven fabrics manufactured by the water-stream-entangling process or the needle punch process in which filaments are entangled by water streams or needles, or the meltblowing or spunbonding process are preferably employed.

The material for the non-woven fabric may be a single kind of fiber or a combination of plural kinds of fibers selected from natural macromolecule fibers such as cotton, rayon and cellulose; synthetic macromolecule fibers such as aliphatic polyamide, polyester, polyvinyl alcohol, polyimide and aromatic polyamide; carbon fibers; glass fibers; and steel wires. Filament fibers having a multilayer structure wherein a layer is formed of a material different than that of its adjoining layer may also be employed. Furthermore, composite fibers having a core-sheath structure in which different materials are used in the inner layer and in the outer layer, a radiate shape, a petal shape, a layered shape or the like, can also be employed.

In the present invention, the important fundamental factors for such non-woven fabrics include to have a structure in which a rubber can enter between fiber filaments and to have a structure in which the filament fibers and a rubber mutually form a continuous layer over a relatively long distance and a relatively wide area. Therefore, the diameter or the maximum cross-sectional dimension of the filament fibers is preferably in the range of 0.1-100 µm, more preferably in the range of 0.1-50µm. The cross section of the filament fibers may have a circular shape or a shape other than a circle. The filament fibers may have a hollow portion.

The length of the filament fibers is preferably 8 mm or more, more preferably 10 mm or more. When the length is less than 8 mm, entanglement of filament fibers is not sufficient and the strength required as a reinforcing layer can not be maintained.

The mass per area (the mass per 1 m²) of the non-woven fabric is preferably in the range of 10 to 300 g, more preferably in the range of 10 to 100 g. When the mass per area is less than 10 g, uneven non-woven fabric may be obtained because maintaining uniformity of the non-woven fabric itself becomes difficult and a composite prepared from the non-woven fabric and a rubber may show great random variations in strength, rigidity, and elongation at break after the composite is vulcanized. On the other hand, when the mass per area exceeds 300 g, a rubber tends not to enter the space inside the non-woven fabric though it depends on the fluidity of the rubber. Such a mass per area is not preferable in view of the peeling resistance of the rubber-non-woven fabric composite when the composite is used as a tire component.

In the present invention, a coating of a metal or metallic compound reactable with sulfur is formed on the surface of the filament fibers constituting the non-woven fabric by the physical vapour deposition (PVD) process or the chemical vapour deposition (CVD) process. The forming of a coating by PVD or CVD has the advantage of causing less environmental pollution because of the use of no solvents. Furthermore, unlike the conventional dip treatment or plating treatment, such a process has another advantage of causing no clogging of a non-woven fabric since a coating is formed in the vapor phase.

Examples of the PVD process applicable to the present invention include the vacuum deposition such as resistance heating deposition and electron beam heating deposition; the molecular beam epitaxy process; the laser ablation process; the sputtering process such as DC sputtering, radio frequency sputtering, magnetron sputtering, ECR sputtering and ion beam; the ion plating process such as radio frequency ion plating; the ionized cluster beam coating process; and the ion beam process. Examples of the CVD process include the heat CVD process such as atmospheric pressure CVD, reduced pressure CVD and organometallic CVD; the photo CVD process; and the plasma enhanced (or assisted) CVD process such as DC plasma enhanced CVD, radio frequency plasma enhanced CVD, microwave plasma enhanced CVD and ECR plasma enhanced CVD. Among them, the sputtering processes, particularly the magnetron sputtering process, are preferably employed.

There are three main reasons for the fact that the sputtering methods are preferred. The first is that a coating can be formed on the surface of a non-woven fabric, a substrate, the temperature of which is low. The second is that the working pressure applied during the coating formation is as relatively high as 5 × 10⁻² Pa to 5 × 10¹ Pa and, therefore, the gas generating from the non-woven fabric does not influence very much. The third reason is that the particle sputtered from a target is highly possible to be scattered by the atmospheric gas such as argon (Ar) before its arrival at the surface of the non-woven fabric, the substrate, resulting from its straight travel, and the so-called "diffraction" of the particle easily occurs. That is, the "diffraction" enables a coating to be formed well on a part of the non-woven fabric non-facing the target or shaded in spite of the extremely complex shape of the non-woven fabric.

The sputtering conditions, particularly the magnetron sputtering conditions are, for example, as follows. The atmospheric gas is an inert gas such as Ar, He, Ne and Kr, particularly Ar. As needed, a reactive gas, for example, O₂ or H₂O as an oxygen series, N₂ or NH₃ as an nitrogen series, or CH₄ as an carbon series may be mixed to the inert gas. The mixing ratio by volume of an inert gas to a reactive gas is 100/0 to 0/100 (inert gas/reactive gas), preferably 100/0 to 20/80.

Furthermore, a bias voltage may be applied to a non-woven fabric, a substrate, as needed. In this case, the bias may be either DC or AC. In the case of AC biasing, the biasing mode is preferably the pulse or the radio frequency (rf). In the case of DC, the bias voltage is in the range of -1 kV to +1 kV.

The gas pressure may have any value at which the sputtering can be performed, but is preferably from 1 × 10⁻² Pa to 5 × 10² Pa, more preferably from 5 × 10⁻² Pa to 1 × 10¹ Pa. A power supply frequency (supplied to a target) may be either known DC or Ac. Generally, a DC power supply or radio frequency (rf) power supply can be employed. A pulse power supply may also be used. The so-called "ionized magnetron sputtering" that causes inductive plasma between a target and a substrate to activate the particles under sputtering may be applied.

The average thickness of a coating formed by such a vapor deposition process is usually from 1 × 10⁻¹⁰ m to 1 × 10⁻⁵ m, preferably from 1 × 10⁻⁹ m to 1 × 10⁻⁶ m, more preferably from 5 × 10⁻⁹ m to 5 × 10⁻⁷ m. If the coating is too thin, the adhesiveness will be insufficient. On the other hand, if too thick, the coating tends to separate from the substrate due to an internal stress of the coating. Such a coating is only required to be formed on the surface of the filaments of the non-woven fabric in at least an amount the sulfurization requires. There is no need for a coating to be formed uniformly. When the coating is exposed to the atmosphere during or after its formation, it sometimes reacts with oxygen or water vapor in the air, resulting in the contamination of impurities such as oxygen and hygrogen into the coating. If necessary, treatment such as plasma treatment, ion plantation, ion irradiation and heat treatment may be conducted after the formation of a coating to improve surface conditions, reactivity, and internal stress of the coating. Furthermore, it is desirable to fully clean the surface of a non-woven fabric, if necessary, before the formation of a coating. Preferred cleaning methods include washing with a solvent, discharge, and a combination of the washing with a solvent and the discharge. The washing effect can be enhanced by a combination of two or more cleaning methods.

The metal or metallic compound reactable with sulfur that can be used in the present invention include alloys, oxides and nitrides. Any material that can be sulfurized during the curing of a rubber through its reaction with sulfur contained in the rubber can be employed. For example, Co, Cu, Zn, Cr, Al, Ag, Ni, Pb, Ti, W, alloys comprising two or more of the above listed metals and their compounds such as oxides, nitrides, carbides, sulfides and sulfates can be employed. Particularly, metals and alloys such as Co, Co/Cr alloy, Cu/Zn alloy and Cu/Al alloy, and their oxides can be preferably used. More preferably, Co and its oxides are used (see, Japanese Patent Laid-Open Publication Nos. Sho. 62-87311, Sho. 62-246287 and Hei. 1-290342). The compounds such as oxides, nitrides and carbides may be both those with a stoichiometric composition and those with a non-stoichiometric composition. Preferred are those having ratios of metal elements greater than stoichiometric values.

It seems that when an uncured rubber is applied onto a coating formed on the surface of a non-woven fabric and adhered thereto on heating, adhesion occurs during the cure of the rubber through the sulfurization of the coating and the rubber. The cure and the sulfurization conflict with each other. In order for both reactions to be appropriately conducted, the reactivities about the reactions must be matched. In the formation of a coating by sputtering, a thin coating of a compound with a moderate sulfurization reactivity can be easily formed by the addition of an appropriate amount of a reaction gas such as oxygen and nitrogen to an inert gas such as Ar during the formation of the coating.

The combination of a non-woven fabric and a rubber to be used in the present invention is conducted by pressing a sheet-like uncured rubber composition from its top and bottom sides or from its one side with a press or a roll, thereby replacing the air present in the non-woven fabric with the rubber.

There are no particular limitations about the rubber composition that can be used in the present invention. For example, the rubber compositions conventionally used for tires can be preferably employed. Therefore, rubber components may be both natural rubbers and synthetic rubbers. Additives such as curing agents, curing accelerators, reinforcing materials, antioxidants and softening agents may be optionally incorporated.

In the figure a cross sectional view of a pneumatic radial tire is shown, which is an embodiment wherein the rubber-based composite material of the present invention is applied. In this tire 1, both ends of a carcass layer 2 in which the cords contained in the layer are arranged in the radial direction of the tire are bent around a pair of right and left bead wires 3a and 3b. Two layers of steel belts 4 are disposed in a ring outside the carcass layer 2 in the radial direction. Furthermore, a tread rubber 6 is arranged in the road contacting surface portion 5 present outside the belt. Further, sidewall rubbers 7a and 7b are stuck on the carcass layer present on both sides of the tread rubber 3 through the rubber-based composite materials 8a and 8b. In this example, the rubber-based composite materials 8a and 8b are, respectively, arranged from the top ends of the bead fillers 9a and 9b to the vicinities of both widest ends of the belt portion with the rubber-based composite materials situated between the carcass layer 2 and the sidewall portions 7a and 7b.

In the present invention, such a rubber-based composite material is provided over a length of at least 10 mm within the regions extending from a bottom end of a bead portion to a widest end of a belt portion situated between a carcass layer and a sidewall or between the carcass layer and an inner liner layer. A rubber-based composite material with a length less than 10 mm adversely results in an insufficient effect of improving the driving stability.

As described above, according to the present invention, the adhesion between a non-woven fabric and a rubber can be enhanced. Furthermore, the use of the rubber-based composite material of the present invention as a reinforcing material for a tire can improve the durability and can reduce the weight thereof. Particularly, its use as a reinforcement for reinforcing the side portions of a radial tire can greatly improve its durability under the running conditions, and the driving stability.

### Examples

The following examples are given for the purpose of illustration of this invention and are not intended as limitation thereof.

The surfaces (both surfaces) of a non-woven fabric (material of the fibers : polyester, fiber diameter : 25 µm, mass : 40 g/m², thickness : 5 mm) were cleaned by a low-pressure plasma method under the conditions given in Table 1 and then a coating of Co and its oxide was formed on the surfaces by sputtering a Co target (purity : 3 N) under the conditions given in Table 1. The power density in the cleaning is defined as the magnitude of the power applied to 1 m² of the non-woven fabric. As a comparative example was prepared a non-woven fabric that had been applied with neither cleaning nor coating with Co.

**Table 1**

| | Cleaning | | | | Coating formation | | |
|---|---|---|---|---|---|---|---|
| | Gas | Pressure (Pa) | Power density (W/m²) | Time (sec) | Ar/O₂ Flow rate ratio | Pressure (Pa) | Average thickness (nm) |
| Example 1 | Ar | 100 | 600 | 10 | 50/0 | 0.7 | 2 × 10¹ |
| Example 2 | Ar | 100 | 600 | 300 | 50/0 | 0.7 | 2 × 10¹ |
| Example 3 | Ar | 100 | 600 | 300 | 50/4 | 0.7 | 2 × 10¹ |
| Example 4 | Ar | 100 | 600 | 300 | 50/13 | 0.7 | 2 × 10¹ |
| Example 5 | O₂ | 100 | 600 | 300 | 50/0 | 0.7 | 2 × 10¹ |
| Example 6 | N₂ | 100 | 600 | 300 | 50/0 | 0.7 | 2 × 10¹ |
| Comparative example | - | - | - | - | - | - | - |

As a reinforcing layer, a rubber-based composite material obtained by integrally covering the non-woven fabric with an uncured rubber from both sides of the fabric, was stuck over a length of 50 mm from the top end of a bead filler between a carcass layer and a sidewall as shown in the figure. The thus obtained raw tire in which an uncured rubber composite material was applied as a fibrous reinforcing layer was shaped and then cured, resulting in a radial tire with a size of 195/60R15 containing a carcass ply of PET 1670 dtex/2. On the other hand, as a conventional example, a radial tire was prepared in the same manner except applying no reinforcing material layer.

As for these tires, the driving stability test and the drum durability test under a high load were conducted.

### <Driving stability>

A car (a domestically produced FF car with a 2000-cc engine) equipped with experimental tires was practically driven under straight running and lane-changing conditions. The driving stability was evaluated from the driver's feeling. The evaluation was classified in comparison to the control as follows:
0 : equivalent to the control.
+2 : possibly slightly better than the control.
+4 : slightly better than the control.
+8: better than the control.

The total points are expressed in indexes based on the control of 100.

### <Drum durability under a high load>

An experimental tire whose internal pressure had been adjusted to the maximum air pressure provided in the JATMA standard was left in a room at 25°C ± 2°C for 24 hours. Then, its internal pressure was readjusted to the maximum air pressure. The tire was rotated on a drum 1.7 m in diameter at a rate of 60 km/h under the application of a load twice the maximum load provided in the JATMA standard. The distance traveled before the occurrence of a failure was measured and indicated as an index based on that of the conventional tire equal to 100. The greater the index, the better the result. The results are given in Table 2.

**Table 2**

| | | Conventional example | Comparative example | Example 1 | Example 2 | Example 3 | Example 4 | Example 5 | Example 6 |
|---|---|---|---|---|---|---|---|---|---|
| Results | Driving stability | 100 | 110 | 118 | 119 | 115 | 113 | 116 | 117 |
| | Practical durability | 100 | 174 | 180 | 193 | 191 | 182 | 190 | 189 |

## Claims

1. A tire (1) comprising a carcass layer (2) extending between a pair of right and left bead wires (3a, 3b), a steel belt (4) disposed in a ring outside the carcass layer (2) in a radial direction, a tread rubber (6) arranged in a road contacting surface portion (5) present outside the belt, and sidewall rubbers (7a, 7b) on the carcass layer (2) present on both sides of the tread rubber, and reinforcing layers (8a, 8b) comprising a rubber-based composite material located between the carcass layer (2) and the sidewalls (7a, 7b), said rubber-based composite material comprising
a non-woven fabric;
a coating of a metal or metallic compound reactable with sulfur, the coating being formed on the surface of filaments constituting the non-woven fabric by a physical vapour deposition (PVD) method or a chemical vapour deposition (CVD) method; and
a rubber that adheres to the coating forming a continuous layer and covering the non-woven fabric.

2. A tire as claimed in claim 1, wherein the metal or metallic compound reactable with sulfur is cobalt or an oxide of cobalt.

3. A tire as claimed in claim 1 or 2, wherein the physical vapour deposition (PVD) method is a sputtering method.

4. A tire as claimed in claim 3, wherein the sputtering method is a magnetron sputtering method.

## Patentansprüche

1. Reifen (1) umfassend eine Reifenunterbauschicht (2), die sich zwischen einem Paar rechter und linker Wulstkerne (3a, 3b) erstreckt, einen Stahlgürtel (4), der sich in einem Ring außerhalb der Reifenunterbauschicht (2) in radialer Richtung befindet, einen Laufflächengummi (6), der in einem außerhalb des Gürtels vorhandenen Straßenbelag-Kontaktabschnitt (5) angeordnet ist, und einen Seitenwandgummi (7a, 7b) an der Reifenunterbauschicht (2), der auf beiden Seiten des Laufflächengummis vorhanden ist, und Verstärkungsschichten (8a, 8b), umfassend einen Verbundstoff aus Gummi, der sich zwischen der Reifenunterbauschicht (2) und den Seitenwänden (7a, 7b) befindet, wobei der Verbundstoff aus Gummi Folgendes umfasst:
einen Vliesstoff;
eine Beschichtung aus Metall oder einer metallischen Zusammensetzung, das/die mit Schwefel reagieren kann, wobei die Beschichtung auf der Oberfläche der den Vliesstoff bildenden Fasern durch ein physikalisches oder ein chemisches Gasphasenabscheidungsverfahren gebildet wird; und
einen Gummi, der an der Beschichtung haftet und so eine durchgehende Schicht bildet und den Vliesstoff bedeckt.

2. Reifen nach Anspruch 1, wobei das Metall oder die metallische Zusammensetzung, das/die mit Schwefel reagieren kann, Kobalt oder ein Kobaltoxid ist.

3. Reifen nach Anspruch 1 oder 2, wobei das physische Gasphasenabscheidungsverfahren ein Sputterverfahren ist.

4. Reifen nach Anspruch 3, wobei das Sputterverfahren ein Magnetron-Sputterverfahren ist.

## Revendications

1. Pneu (1) comprenant une couche de carcasse (2) s'étendant entre une paire de tringles droite et gauche (3a, 3b), une courroie en acier (4) disposée dans un anneau à l'extérieur de la couche de carcasse (2) dans une direction radiale, une bande de roulement (6) disposée dans une portion de surface en contact avec la route (5) présente à l'extérieur de la courroie, et des pièces de caoutchouc sur le flanc (7a, 7b) sur la couche de carcasse (2) présentes sur les deux côtés de la bande de roulement, et des couches de renforcement (8a, 8b) comprenant un matériau composite à base de caoutchouc situés entre la couche de carcasse (2) et les flancs (7a, 7b), ledit matériau composite à base de caoutchouc comprenant
un tissu non tissé ;
un revêtement de métal ou d'un composé métallique réagissant avec le soufre, le revêtement étant formé sur la surface de filaments constituant le tissu non tissé par un procédé de dépôt physique en phase vapeur (PVD) ou un procédé de dépôt chimique en phase vapeur (CVD) ; et
un caoutchouc adhérant au revêtement formant une couche continue et couvrant la tissu non tissé.

2. Pneu tel que revendiqué dans le revendication 1, dans lequel le métal ou le composé métallique réagissant avec le soufre est du cobalt ou un oxyde de cobalt.

3. Pneu tel que revendiqué dans la revendication 1 ou 2, dans lequel le procédé de dépôt physique en phase vapeur (PVD) est un procédé de pulvérisation cathodique.

4. Pneu tel que revendiqué dans la revendication 3, dans lequel le procédé de pulvérisation cathodique est un procédé de pulvérisation cathodique magnétron.
